# EUROPÄISCHE PATENTSCHRIFT

(11) **EP 4 168 812 B1**
(45) Veröffentlichungstag und Bekanntmachung des Hinweises auf die Patenterteilung: **22.04.2026**
(21) Anmeldenummer: 21773064.7
(22) Anmeldetag: 03.09.2021
(51) Int. Cl.: G01R 31/12

(54) **ABLEITERSYSTEM PARALLEL GESCHALTETER ABLEITER UND VERFAHREN ZUM DETEKTIEREN VON DEFEKTEN DER ABLEITER**
ARRESTER SYSTEM OF PARALLEL-CONNECTED ARRESTERS, AND METHOD FOR DETECTING FAULTS OF THE ARRESTERS
SYSTÈME DE DISPOSITIFS D'ARRÊT COMPOSÉ DE DISPOSITIFS D'ARRÊTS CONNECTÉS EN PARALLÈLE ET PROCÉDÉ DE DÉTECTION DE DÉFAUTS DE DISPOSITIFS D'ARRÊT

(30) Priorität: 14.09.2020 DE 102020211487
(43) Veröffentlichungstag der Anmeldung: 26.04.2023
(73) Patentinhaber: Siemens Energy Global GmbH & Co. KG, 81739 München (DE)
(72) Erfinder: HILKER, Thomas, 14532 Stahnsdorf (DE); ROGGOW, Henrik, 13403 Berlin (DE)
(86) Internationale Anmeldenummer: PCT/EP2021/074403
(87) Internationale Veröffentlichungsnummer: WO 2022/053409

(56) Entgegenhaltungen:
- EP-A1- 2 333 925
- CN-A- 105 388 374
- CN-A- 105 552 874
- CN-A- 106 501 631
- DE-B3- 102015 013 433
- JP-A- H04 206 375

## Beschreibung

Die Erfindung betrifft ein Ableitersystem und ein Verfahren zum Detektieren von Defekten an parallel geschalteten Ableitern, mit wenigstens zwei parallel geschalteten Ableitern, welche jeweils einen Sensor zur Bestimmung von Leckströmen umfassen.

Ableitersysteme umfassen mehr als einen Ableiter, welche z. B. parallel zueinander geschaltet sind. Überspannungsableiter für Mittelspannungsanwendungen gewährleisten einen zuverlässigen Überspannungsschutz für Mittelspannungsanwendungen im Bereich von tausend Volt bis hin zu 71,5 kV. Ableiter für Hochspannungsanwendungen schützen Geräte in Anlagen für Anwendungen im Bereich von bis zu 1200 kV. Überspannungen, welche z. B. durch direkte oder nahegelegene Blitzeinschläge, durch Magnetstürme, insbesondere von der Sonne verursacht, durch elektromagnetische Pulse, **d. h.** EMP's, durch elektrostatische Entladungen oder Schaltvorgänge im Stromnetz und/oder Geräten entstehen, weisen teilweise große Momentan-Leistungen auf. Diese können zur Beschädigung und/oder Zerstörung von Geräten, Anlagen und/oder Leitungen sowie Stromnetzen führen. Ableitersysteme schützen Geräte und/oder Anlagen, insbesondere Stromerzeuger und/oder Stromverbraucher, im Stromnetz und/oder Leitungen sowie das Stromnetz selbst durch einen Abbau von Überspannungen.

Für einen zuverlässigen Schutz sind funktionstüchtige, unbeschädigte Ableiter unerlässlich. Dafür wird z. B. an Ableitern in der Mittel- und/oder Hochspannung eine Überwachung von Leckströmen durchgeführt, um Beschädigungen von Ableitern frühzeitig zu erkennen, wie z. B. aus der CN106501631A und der CN105388374A bekannt ist. Der Leckstrom eines Ableiters darf einen definierten Grenzwert nicht überschreiten, da der Ableiter anderenfalls thermisch instabil wird und eine hohe Ausfallwahrscheinlichkeit besteht. Allerdings führen verschiedene Prozesse, z.B. temporäre Überlastung oder Alterung von Ableitern, zu einer Veränderung von Leckströmen. Dadurch ist eine Bewertung eines Leckstromes nur möglich, wenn das Langzeitverhalten des Leckstroms beurteilt wird. Eine solche Trendbetrachtung ermöglicht einen rechtzeitigen Austausch von defekten Ableitern und ermöglich das Vermeiden von Komplettausfällen.

Zur Beurteilung des Zustandes eines Ableiters wird das Langzeitverhalten des Ableiter-Leckstroms beobachtet. Steigt der Strom kontinuierlich, ist davon auszugehen, dass der Ableiter einen Defekt aufweist. Langzeitbeobachtungen sind jedoch aufwendig, kostenintensiv und in der Regel nur von einer zentralen Leitwarte aus möglich, in welcher Messergebnisse gespeichert und die gespeicherten Ergebnisse über lange Zeiträume hinweg überwacht werden. Eine kurzzeitige Beurteilung z. B. von Wartungspersonal vor Ort ist somit nicht möglich, oder nur sehr eingeschränkt möglich.

Aufgabe der vorliegenden Erfindung ist es, ein Ableitersystem und ein Verfahren zum Detektieren von Defekten an parallel geschalteten Ableitern anzugeben, welche die zuvor beschriebenen Probleme lösen. Insbesondere ist es Aufgabe, ein Ableitersystem anzugeben, welches in kurzen Zeiträumen ermöglicht, Defekte an Ableitern bzw. defekte Ableiter zu detektieren und/oder zu identifizieren, um Beschädigungen im Stromnetz und/oder an Geräten sowie Anlagen im Netz zu vermeiden und Kosten zu sparen.

Die angegebene Aufgabe wird erfindungsgemäß durch ein Ableitersystem mit den Merkmalen gemäß Patentanspruch 1 und/oder durch ein Verfahren zum Detektieren von Defekten an einem Ableitersystem mit parallel geschalteten Ableitern gemäß Patentanspruch 8 gelöst. Vorteilhafte Ausgestaltungen des erfindungsgemäßen Ableitersystems und/oder des erfindungsgemäßen Verfahrens zum Detektieren von Defekten an parallel geschalteten Ableitern, insbesondere an Ableitern eines zuvor beschriebenen Ableitersystems, sind in den Unteransprüchen angegeben. Dabei sind Gegenstände der Hauptansprüche untereinander und mit Merkmalen von Unteransprüchen sowie Merkmale der Unteransprüche untereinander kombinierbar.

Ein erfindungsgemäßes Ableitersystem umfasst wenigstens zwei parallel geschaltete Ableiter, welche jeweils einen Sensor zur Bestimmung von Leckströmen umfassen. Ein Monitoringsystem ist vom Ableitersystem umfasst, welches ausgebildet ist durch Vergleich von Sensordaten Defekte an Ableitern zu detektieren.

Für parallel geschaltete Ableiter z.B. in HVDC- oder FSC-Anwendungen besteht die Möglichkeit zur kurzfristigen Beurteilung des Zustandes einzelner Ableiter. Jeder der parallel geschalteten Ableiter wird z. B. mit einer Möglichkeit zur Leckstrom-Messung ausgestattet. Diese Messung kann z. B. induktiv und/oder über einen Shuntwiderstand erfolgen, wobei eine Spule und/oder der Widerstand einen Sensor für Ströme darstellen. Die Leckstrom-Information wird z. **b.** in eine Auswerteeinheit, welche Teil eines Monitoringsystems ist, eingespeist. Dort werden die Leckstrom-Beträge der einzelnen Ableiter miteinander verglichen. Führt eine kurzzeitige Überlastung zu einem Anstieg des Leckstromes, dann wird dieser Anstieg bei allen Ableitern festgestellt.

Wird aber nur an einem Ableiter ein Anstieg des Leckstromes festgestellt, während der Leckstrom der anderen Ableiter unverändert bleibt, dann weist der Ableiter einen Defekt oder einen drohenden Defekt auf. Entsprechende Maßnahmen können eingeleitet werden. Alternativ zum Leckstrom ist z. B. die Messung der Temperatur der einzelnen Ableiter möglich. Der thermische Ausfall eines Ableiters wird durch einen Anstieg der Ohm'schen Komponente des Leckstromes verursacht. Der Ohm'sche Anteil im Leckstrom und die Temperatur des Ableiters korrelieren direkt. Ein Vergleich der Temperaturen der einzelnen Ableiter besitzt damit die gleiche Aussagekraft wie die vergleichende Leckstrom-Messung.

Das Monitoringsystem des erfindungsgemäßen Ableitersystems, mit wenigstens zwei parallel geschalteten Ableitern, wobei Ableiter jeweils einen Sensor zur Bestimmung von Leckströmen umfassen, ist ausgebildet durch Vergleich von Sensordaten Defekte an Ableitern bzw. defekte Ableiter innerhalb kurzer Zeiträume zu detektieren und/oder zu identifizieren, um Beschädigungen im Stromnetz und/oder an Geräten sowie Anlagen im Netz zu vermeiden und Kosten zu sparen.

Das Monitoringsystem kann ausgebildet sein, durch Kurzzeitmessung der Sensoren, insbesondere Messungen mit einer Dauer im Bereich von Nanosekunden, Millisekunden, Sekunden und/oder Minuten, Defekte an Ableitern zu detektieren. Ein zuvor beschriebener Vergleich von Sensordaten macht eine Detektion von Defekten an Ableitern durch Kurzzeitmessungen möglich.

Das Monitoringsystem kann ausgebildet sein, durch Vergleich der Einzelströme über einzelne Ableiter, insbesondere über jeden einzelnen Ableiter getrennt von anderen Ableitern, Defekte zu detektieren. Einzelströme über einzelne Ableiter sind durch Sensoren, insbesondere Shuntwiderstände, Spulen und/oder optische Sensoren, z. B in Form von Lichtwellenleitern, an den jeweiligen Ableitern einfach und kostengünstig messbar.

Das Monitoringsystem ist ausgebildet, durch Vergleich der Temperatur einzelner Ableiter untereinander, insbesondere der Temperatur jedes Ableiters mit allen anderen Ableitern, Defekte zu detektieren. Temperaturen einzelner Ableiter werden durch Sensoren, insbesondere Temperatursensoren wie z. B. Thermistoren, Thermoelementen, Thermosäulen, digitalen und Platin- und/oder Siliziumsensoren, und/oder Wärmebildkameras, an den jeweiligen Ableitern insbesondere einfach und kostengünstig gemessen. Sensoren wie z. B. Wärmebildkameras ermöglichen darüber hinaus eine Temperaturmessung mehrerer Ableiter gleichzeitig, aufgelöst für jeden einzelnen Ableiter. Dabei bilden die optischen/thermischen Elemente, **d. h.** die im Wärmebild als Pixel dargestellten einzelnen Messpunkte, welche auf einen Ableiter ausgerichtet sind und den Ableiter thermisch abbilden, den zum Ableiter zugeordneten Sensor.

Das Monitoringsystem kann wenigstens eine Datenverarbeitungseinheit, Datenspeichereinheit, Datenanzeigeeinheit und/oder Datenübermittlungseinheit umfassen. Die Einheiten ermöglichen insbesondere einen automatischen Vergleich der Sensordaten, eine Speicherung von Daten insbesondere für Langzeitdarstellungen, eine Weiterverarbeitung der Daten und/oder Aufbereitung der Daten z. B. für Warnmeldungen, graphische Darstellungen und/oder Datenübermittlungen, sowie eine Darstellung und/oder Datenübermittlung, z. B. an eine zentrale Leitwarte und/oder Handheldgeräte wie z. B. Laptops, Handys und/oder Tablets.

Das Monitoringsystem kann räumlich lokal am Ort der Ableiter angeordnet sein. Damit ist eine hohe Zuverlässigkeit, ohne Verbindungsprobleme und Datenübermittlungsfehler möglich, und eine lokale Abfrage für z. B. Wartungspersonal vor Ort wird ermöglicht.

Das Monitoringsystem kann eine räumlich entfernt angeordnete zentrale Leitstelle umfassen und/oder mit einer räumlich entfernt angeordneten zentralen Leitstelle informationstechnisch verbunden sein, insbesondere über LAN, Modbus, Funk und/oder Internet. Dadurch ist eine Fernüberwachung und/oder Fernwartung möglich, mit wenig Personal und damit verbunden geringen Kosten. Eine Steuerung und/oder Regelung des Stromnetzes, und/oder von Komponenten des Stromnetzes wie z. B. Stromerzeugern, Stromverbrauchern, Schaltern, Messeinrichtungen, und/oder Leitungen, ist dadurch möglich. Defekte Ableiter bzw. mit diesen verbundene Komponenten können zentral dadurch abgeschaltet bzw. vom Netz getrennt werden.

Die Ableiter können ausgebildet sein für Mittel- und/oder Hochspannungen. Die zuvor beschriebenen Vorteile wirken insbesondere für Mittel- und Hochspannungsanwendungen vorteilhaft. Dabei sind Mittelspannungsanwendungen im Bereich von tausend Volt bis hin zu 71,5 kV und Hochspannungsanwendungen im Bereich von bis zu 1200 kV angesiedelt.

Ein erfindungsgemäßes Verfahren zum Detektieren von Defekten an parallel geschalteten Ableitern, insbesondere an Ableitern eines zuvor beschriebenen Ableitersystems, umfasst, dass ein Vergleich insbesondere aktueller Messwerte der Ableiter und/oder von Sensoren der Ableiter erfolgt, wobei ein Defekt bei Abweichungen zwischen Messwerten unterschiedlicher Ableiter detektiert wird, und bei im Wesentlichen gleichen Messwerten der Ableiter, insbesondere aller Ableiter, das Ableitersystem als defektfrei identifiziert wird.

Messwerte der Ableiter können Stromwerte umfassen, insbesondere Leckstromwerte, und/oder Messwerte der Ableiter können Temperaturwerte umfassen, insbesondere die Temperatur einzelner Ableiter.

Messwerte können durch Sensoren jeweils an jedem Ableiter gemessen werden, insbesondere für Strom und/oder Temperatur jedes Ableiters des Ableitersystems.

Messwerte insbesondere aller Ableiter können gemeinsam gemessen werden, insbesondere Temperaturwerte durch wenigstens eine Wärmebildkamera.

Ein Vergleich von Messwerten der Ableiter und/oder von Sensoren der Ableiter kann erfolgen, welche in einem kurzen Zeitraum gemessen wurden, insbesondere in einem Zeitraum von Nanosekunden, Millisekunden, Sekunden und/oder Minuten, und/oder das Verfahren kann, insbesondere wiederholt, in einem Zeitraum von Nanosekunden, Millisekunden, Sekunden und/oder Minuten durchgeführt und/oder jeweils abgeschlossen werden.

Bei einer Detektion wenigstens eines defekten Ableiters kann eine Warnmeldung und/oder Information lokal und/oder in wenigstens einer zentralen Leitwarte und/oder auf Handheldgeräten ausgegeben werden. Die Ausgabe kann z. B. automatisch, insbesondere in Form eines Warntons und/oder eines Lichtsignals und/oder einer elektronischen Warnmeldung erfolgen.

Die Vorteile des erfindungsgemäßen Verfahrens zum Detektieren von Defekten an parallel geschalteten Ableitern, insbesondere an Ableitern eines zuvor beschriebenen Ableitersystems, gemäß Anspruch 9 sind analog den zuvor beschriebenen Vorteilen des erfindungsgemäßen Ableitersystems gemäß Anspruch 1 und umgekehrt.

Im Folgenden wird ein Ausführungsbeispiel der Erfindung schematisch in der einzigen Figur dargestellt und nachfolgend näher beschrieben.

Dabei zeigt die
- Figur: schematisch das Prinzip eines erfindungsgemäßen Ableitersystems 1, mit wenigstens zwei parallel geschalteten Ableitern 2, welche jeweils einen Sensor 3 zur Bestimmung von Leckströmen umfassen, und mit einem Monitoringsystem 4, welches ausgebildet ist durch Vergleich von Sensordaten Defekte an Ableitern 2 insbesondere in kurzen Zeitintervallen zu detektieren.

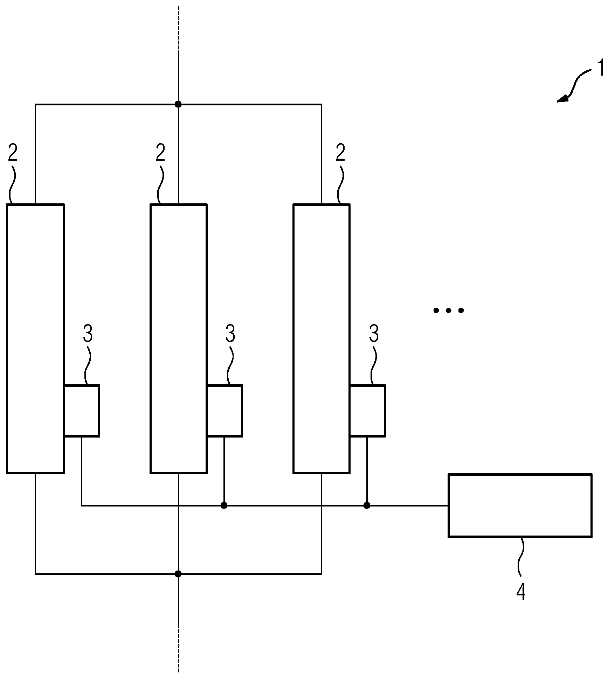

In Figur 1 ist schematisch das Prinzip eines erfindungsgemäßen Ableitersystems 1 dargestellt. Das Ableitersystem 1 umfasst wenigstens zwei parallel geschalteten Ableiter 2, in der Figur als drei Ableiter 2 dargestellt mit dem Dreipunkte-Zeichen ... für weitere Ableiter 2. Das Ableitersystems 1 kann alternativ auch nur zwei Ableiter 2 umfassen. Die Ableiter 2 weisen jeweils einen Sensor 3 zur Bestimmung von Leckströmen auf. Weitere Sensoren können umfasst sein von einem Ableiter 2 oder mehrere Ableiter 2 können einen Sensor 3 umfassen, welcher ausgebildet ist, Messwerte aufgelöst für jeden Ableiter 2 insbesondere einzeln zu ermitteln. Der Einfachheit halber ist in der Figur nur ein Sensor 3 für jeden Ableiter 2 dargestellt. Die Ableiter 2 sind z. B. als luft- oder gasisolierte Überspannungsableiter ausgebildet, z. B. als Metalloxid-Ableiter mit einem Isolatorgehäuse, insbesondere aus Keramik, Silikon und/oder Kompositwerkstoffen, welches z. B. Rippen am äußeren Umfang aufweist, oder mit einem Metallgehäuse. Einzelheiten der Ableiter sind in der Figur der Einfachheit halber nicht dargestellt.

Sensoren 3 sind z. B. ausgebildet in Form von Shuntwiderständen, Spulen und/oder optische Sensoren, insbesondere in Form von Lichtwellenleitern an den jeweiligen Ableitern 2. Damit sind Einzelströme über einzelne Ableiter 2 messbar. Alternativ oder zusätzlich umfassen und/oder sind Sensoren 3 Temperatursensoren, welche ausgebildet sind Temperaturen einzelner Ableiter zu messen. Temperatursensoren sind z. B. Thermistoren, Thermoelementen, Thermosäulen, digitalen und Platin- und/oder Siliziumsensoren, und/oder Wärmebildkameras. Sensoren wie z. B. Wärmebildkameras ermöglichen darüber hinaus eine Temperaturmessung mehrerer Ableiter gleichzeitig, mit einer Auflösung der Temperatur für jeden einzelnen Ableiter.

Das erfindungsgemäße Ableitersystem 1, wie es in der Figur dargestellt ist, umfasst ein Monitoringsystem 4, welches ausgebildet ist durch Vergleich von Sensordaten Defekte an Ableitern 2 insbesondere in kurzen Zeitintervallen zu detektieren. Kurze Zeitintervalle sind z. B. Zeitspannen von Nanosekunden, Millisekunden, Sekunden und/oder Minuten. Kurzzeitmessung der Sensoren 3, insbesondere Messungen mit einer Dauer im Bereich von Nanosekunden, Millisekunden, Sekunden und/oder Minuten, ermöglichen eine Detektion von Defekten an einzelnen Ableitern 2 und/oder an Gruppen von Ableitern. Das Monitoringsystem 4 umfasst wenigstens eine Datenverarbeitungseinheit, welche die Sensordaten zeitnah, insbesondere sofort, verarbeitet und auswertet. Dadurch kann ein Defekt an einem Ableiter 2 sofort oder zumindest zeitnah, d. h. innerhalb von z. B. Nanosekunden, Millisekunden, Sekunden und/oder Minuten, angezeigt werden und/oder z. B. ein Alarm ausgelöst werden.

Räumlich lokal am Ort der Ableiter 2 angeordnet, wird ein detektierter Defekt an einem Ableiter 2 durch ein z. B. lokal angeordnetes Monitoringssystem 4 angezeigt, insbesondere an einem Monitor, einer Warnleuchte und/oder auf Handheldgeräten, insbesondere für Wartungspersonal vor Ort. Das Monitoringssystem 4 umfasst z. B. eine Datenspeichereinheit, welche Sensordaten speichert und die Wiedergabe des zeitlichen Verlaufs von Messwerten bzw. Sensordaten ermöglicht. Datenanzeigeeinheiten vor Ort umfassen z. B. wie zuvor beschrieben Monitore, Warnleuchten und/oder Handheldgeräte, insbesondere Laptops, Handys und/oder Tablets. Datenübermittlungseinheiten, insbesondere drahtgebunden, z. B. LAN-Kabel, und/oder für Funk, z. B. Bluetooth, W-Lan, Mobilfunk, sind ausgebildet, Daten von Sensoren, und/oder der Datenverarbeitungs- und/oder Datenspeichereinheit, auf Datenausgabeeinheiten zu übertragen.

Das Monitoringsystem 4 umfasst alternativ oder zusätzlich eine räumlich entfernt angeordnete zentrale Leitstelle. Ein detektierter Defekt an einem Ableiter 2 wird z. B. durch das Monitoringssystem 4 entfernt vom Ableiter 2, insbesondere viele Kilometer entfernt, in der zentralen Leitstelle oder auf Handheldgeräten, wie zuvor beschrieben angezeigt. Eine Datenverbindung zwischen der zentralen Leitstelle und den Sensoren 3 der Ableiter 2 und/oder einer lokalen Datenübermittlungseinheit ermöglicht die Datenübertragung der Sensordaten. Eine Datenverarbeitungs- und/oder Datenspeichereinheit, welche Sensordaten speichert und die Wiedergabe des zeitlichen Verlaufs von Messwerten bzw. Sensordaten ermöglicht, ist vor Ort oder in der Leitwarte bzw. den Handheldgeräten angeordnet. Eine Datenübermittlung erfolgt insbesondere drahtgebunden, z. B. per LAN-Kabel, und/oder über Funk, z. B. Mobilfunk. Bei einem Defekt oder einem aus den Daten prognostizierten Defekt von Ableitern 2, wird Wartungspersonal vor Ort geschickt oder Wartungspersonal vor Ort wird informiert, um eine Wartung und/oder einen Austausch des defekten Ableiters 2 vorzunehmen. Zentral oder dezentral können weiter Maßnahmen getroffen werden, wie z. B. eine Ab- und/oder Zuschaltung von Geräten, elektrischen Leitungen und/oder Stromverbrauchern, Stromerzeugern, und/oder Stromnetzen.

Ein Defekt eines oder mehrerer Ableiter 2 wird detektiert bzw. identifiziert durch Vergleich insbesondere aktueller Messwerte der Ableiter 2 und/oder von Sensoren 3 der Ableiter 2. Eine Messung und/oder ein Vergleich von Messwerten der Ableiter bzw. der Sensoren der Ableiter erfolgt in einem kurzen Zeitraum oder über lange Zeiträume hinweg, z. B. über Stunden, Tage, und/oder Jahre. Ein Monitoring der Ableiter und/oder von Sensoren der Ableiter kann kurz oder über lange Zeiträume hinweg erfolgen, insbesondere kontinuierlich oder in regelmäßigen zeitlichen Abständen. Ein Defekt liegt vor, bei Abweichungen zwischen Messwerten unterschiedlicher Ableiter 2. Abweichungen in bestimmten Toleranzen können zulässig sein, wobei im Weiteren Abweichungen außerhalb der insbesondere vordefinierten Toleranzen zur Identifizierung von Defekten der Ableiter 2 dienen. Bei im Wesentlichen gleichen Messwerten der Ableiter 2 und/oder von Sensoren 3 der Ableiter 2, insbesondere aller Ableiter 2 bzw. Sensoren 3, wird das Ableitersystem 1 als defektfrei identifiziert.

Die zuvor beschriebenen Ausführungsbeispiele können untereinander kombiniert werden und/oder können mit dem Stand der Technik kombiniert werden. So können z. B. Ableitersysteme Ableiter für Mittel- und/oder Hochspannungen umfassen. Ableiter sind z. B. Überspannungsableiter für luft- und/oder gasisolierte Anwendungen. Sensoren sind z. B. direkt vom Ableiter umfasst und/oder räumlich am Ableiter angeordnet, insbesondere Spulen und/oder Shuntwiderstände und/oder Temperatursensoren in direktem Kontakt zum Ableiter, oder räumlich entfernt vom Ableiter angeordnet, insbesondere Wärmebildkameras. Datenerfassungs-, Datenverarbeitungs-, Datenspeicher und/oder Datenübermittlungseinrichtungen können lokal am Ableiter oder nahe dem Ableiter insbesondere für mehrere Ableiter angeordnet sein, und/oder zentral oder dezentral entfernt, in wenigstens einer Leitwarte oder Computern, Handheldgeräten und/oder der Cloud.

### Bezugszeichen:

- 1: Ableitersystem
- 2: Ableiter
- 3: Sensor
- 4: Monitoringsystem

## Patentansprüche

1. Ableitersystem (1) mit wenigstens zwei parallel geschalteten Ableitern (2), welche jeweils einen Sensor (3) zur Bestimmung von Leckströmen umfassen, wobei ein Monitoringsystem (4) umfasst ist, welches ausgebildet ist durch Vergleich von Sensordaten Defekte an Ableitern (2) zu detektieren,
**dadurch gekennzeichnet, dass** das Monitoringsystem (4) ausgebildet ist, durch Vergleich der Temperatur einzelner Ableiter (2) untereinander, insbesondere der Temperatur jedes Ableiters (2) mit allen anderen Ableitern (2), gemessen durch Sensoren, wobei der Ohm'sche Anteil im Leckstrom und die Temperatur des Ableiters korrelieren und der thermische Ausfall eines Ableiters durch einen Anstieg der Ohm'schen Komponente des Leckstromes verursacht wird, Defekte zu detektieren.

2. Ableitersystem (1) nach Anspruch 1, **dadurch gekennzeichnet, dass** das Monitoringsystem (4) ausgebildet ist, durch Kurzzeitmessung der Sensoren (3), insbesondere Messungen mit einer Dauer im Bereich von Nanosekunden, Millisekunden, Sekunden und/oder Minuten, Defekte an Ableitern (2) zu detektieren.

3. Ableitersystem (1) nach einem der vorhergehenden Ansprüche, **dadurch gekennzeichnet, dass** das Monitoringsystem (4) ausgebildet ist, durch Vergleich der Einzelströme über einzelne Ableiter (2), insbesondere über jeden einzelnen Ableiter (2) getrennt von anderen Ableitern, Defekte zu detektieren.

4. Ableitersystem (1) nach einem der vorhergehenden Ansprüche, **dadurch gekennzeichnet, dass** das Monitoringsystem (4) wenigstens eine Datenverarbeitungseinheit, Datenspeichereinheit, Datenanzeigeeinheit und/oder Datenübermittlungseinheit umfasst.

5. Ableitersystem (1) nach einem der vorhergehenden Ansprüche, **dadurch gekennzeichnet, dass** das Monitoringsystem (4) räumlich lokal am Ort der Ableiter (2) angeordnet ist.

6. Ableitersystem (1) nach einem der vorhergehenden Ansprüche, **dadurch gekennzeichnet, dass** das Monitoringsystem (4) eine räumlich entfernt angeordnete zentrale Leitstelle umfasst und/oder mit einer räumlich entfernt angeordneten zentralen Leitstelle informationstechnisch verbunden ist, insbesondere über LAN, Funk und/oder Internet.

7. Ableitersystem (1) nach einem der vorhergehenden Ansprüche, **dadurch gekennzeichnet, dass** die Ableiter (2) ausgebildet sind für Mittel- und/oder Hochspannungen.

8. Verfahren zum Detektieren von Defekten an einem Ableitersystem mit parallel geschalteten Ableitern (2) nach einem der vorhergehenden Ansprüche, **dadurch gekennzeichnet, dass** ein Vergleich insbesondere aktueller Messwerte der Ableiter (2) und/oder von Sensoren (3) der Ableiter (2) erfolgt, wobei ein Defekt bei Abweichungen zwischen Messwerten unterschiedlicher Ableiter (2) detektiert wird, und bei im Wesentlichen gleichen Messwerten der Ableiter (2), insbesondere aller Ableiter (2), das Ableitersystem (1) als defektfrei identifiziert wird.

9. Verfahren nach Anspruch 8, **dadurch gekennzeichnet, dass** Messwerte der Ableiter (2) Stromwerte umfassen, insbesondere Leckstromwerte, und/oder dass Messwerte der Ableiter Temperaturwerte umfassen, insbesondere die Temperatur einzelner Ableiter (2).

10. Verfahren nach einem der Ansprüche 8 oder 9, **dadurch gekennzeichnet, dass** Messwerte durch Sensoren (3) jeweils an jedem Ableiter (2) gemessen werden, insbesondere für Strom und/oder Temperatur jedes Ableiters (2) des Ableitersystems (1).

11. Verfahren nach einem der Ansprüche 8 bis 10, **dadurch gekennzeichnet, dass** Messwerte insbesondere aller Ableiter (2) gemeinsam gemessen werden, insbesondere Temperaturwerte durch wenigstens eine Wärmebildkamera.

12. Verfahren nach einem der Ansprüche 8 bis 11, **dadurch gekennzeichnet, dass** ein Vergleich von Messwerten der Ableiter (2) und/oder von Sensoren (3) der Ableiter (2) erfolgt, welche in einem kurzen Zeitraum gemessen wurden, insbesondere in einem Zeitraum von Nanosekunden, Millisekunden, Sekunden und/oder Minuten, und/oder dass das Verfahren, insbesondere wiederholt in einem Zeitraum von Nanosekunden, Millisekunden, Sekunden und/oder Minuten durchgeführt und/oder jeweils abgeschlossen wird.

13. Verfahren nach einem der Ansprüche 8 bis 12, **dadurch gekennzeichnet, dass** bei einer Detektion wenigstens eines defekten Ableiters (2) eine Warnmeldung und/oder Information lokal und/oder in wenigstens einer zentralen Leitwarte und/oder auf Handheldgeräten ausgegeben wird, insbesondere automatisch, insbesondere in Form eines Warntons und/oder eines Lichtsignals und/oder einer elektronischen Warnmeldung.

## Claims

1. An arrester system (1) having at least two parallel-connected arresters (2), each of which comprising a sensor (3) for determining leakage currents, wherein a monitoring system (4) is comprised that is designed to detect faults in arresters (2) by comparing sensor data, **characterised in that** the monitoring system (4) is designed to detect faults by comparing the temperature of individual arresters (2) with one another, in particular the temperature of each arrester (2) with all other arresters (2), measured by sensors, wherein the ohmic portion in the leakage current and the temperature of the arrester correlate and the thermal failure of an arrester is caused by an increase in the ohmic component of the leakage current.

2. The arrester system (1) according to claim 1, **characterised in that** the monitoring system (4) is designed to detect faults in the arresters (2) by short-term measurement of the sensors (3), in particular measurements with a duration in a range of nanoseconds, milliseconds, seconds and/or minutes.

3. The arrester system (1) according to any one of the preceding claims, **characterised in that** the monitoring system (4) is designed to detect faults by comparing the individual currents through individual arresters (2), in particular through each individual arrester (2) separately from other arresters.

4. The arrester system (1) according any one of the preceding claims, **characterised in that** the monitoring system (4) comprises at least one data processing unit, data storage unit, data display unit and/or data transmission unit.

5. The arrester system (1) according to any one of the preceding claims, **characterised in that** the monitoring system (4) is arranged spatially locally at the location of the arresters (2).

6. The arrester system (1) according to any one of the preceding claims, **characterised in that** the monitoring system (4) comprises a spatially remotely arranged central control station and/or is connected via information technology to a spatially remotely arranged central control station, in particular via LAN, radio and/or internet.

7. The arrester system (1) according to any one of the preceding claims, **characterised in that** the arresters (2) are designed for medium and/or high voltages.

8. A method for detecting faults in an arrester system having parallel-connected arresters (2) according to any one of the preceding claims, **characterised in that** a comparison of in particular up-to-date measurement values of the arresters (2) and/or of sensors (3) of the arresters (2) is carried out, wherein a fault is detected in case of deviations between measurement values of different arresters (2), and the arrester system (1) is identified as fault-free in case of substantially identical measurement values of the arresters (2), in particular of all arresters (2).

9. The method according to claim 8, **characterised in that** measurement values of the arresters (2) comprise current values, in particular leakage current values, and/or that measurement values of the arresters comprise temperature values, in particular the temperature of individual arresters (2).

10. The method according to any one of claims 8 or 9, **characterised in that** measurement values are measured by sensors (3) on each arrester (2), in particular for current and/or temperature of each arrester (2) of the arrester system (1).

11. The method according to any one of claims 8 to 10, **characterised in that** measurement values in particular of all arresters (2) are measured together, in particular temperature values by at least one thermal imaging camera.

12. The method according to any one of claims 8 to 11, **characterised in that** a comparison of measurement values of the arresters (2) and/or of sensors (3) of the arresters (2) is carried out, which were measured over a short period, in particular over a period of nanoseconds, milliseconds, seconds and/or minutes, and/or that the method is, in particular repeatedly over a period of nanoseconds, milliseconds, seconds and/or minutes, performed and/or concluded, respectively.

13. The method according to any one of claims 8 to 12, **characterised in that**, upon detection of at least one faulty arrester (2), a warning message and/or information is output locally and/or in at least one central control room and/or on handheld devices, in particular automatically, in particular in form of a warning sound and/or a light signal and/or an electronic warning message.

## Revendications

1. Système de parafoudres (1) comprenant au moins deux parafoudres (2) connectés en parallèle, chacun comprenant un capteur (3) pour déterminer les courants de fuite, un système de surveillance (4) étant inclus, lequel est configuré pour détecter des défauts sur les parafoudres (2) par comparaison des données de capteur, **caractérisé en ce que** le système de surveillance (4) est configuré pour détecter des défauts par comparaison de la température de parafoudres individuels (2) entre eux, en particulier la température de chaque parafoudre (2) avec tous les autres parafoudres (2), mesurée par des capteurs, la composante ohmique dans le courant de fuite et la température du parafoudre étant corrélées et la défaillance thermique d'un parafoudre étant causée par une augmentation de la composante ohmique du courant de fuite.

2. Système de parafoudres (1) selon la revendication 1, **caractérisé en ce que** le système de surveillance (4) est configuré pour détecter des défauts sur des parafoudres (2) par une mesure de courte durée des capteurs (3), en particulier des mesures avec une durée dans la plage de nanosecondes, millisecondes, secondes et/ou minutes.

3. Système de parafoudres (1) selon l'une des revendications précédentes, **caractérisé en ce que** le système de surveillance (4) est configuré pour détecter des défauts par comparaison des courants individuels passant par des parafoudres (2) individuels, en particulier par chaque parafoudre (2) individuel séparément des autres parafoudres, afin de détecter des défauts.

4. Système de parafoudres (1) selon l'une des revendications précédentes, **caractérisé en ce que** le système de surveillance (4) comprend au moins une unité de traitement de données, une unité de stockage de données, une unité d'affichage de données et/ou une unité de transmission de données.

5. Système de parafoudres (1) selon l'une des revendications précédentes, **caractérisé en ce que** le système de surveillance (4) est disposé spatialement de manière locale sur le site des parafoudres (2).

6. Système de parafoudres (1) selon l'une des revendications précédentes, **caractérisé en ce que** le système de surveillance (4) comprend un poste de commande central disposé à distance spatiale et/ou est connecté par voie informatique à un poste de commande central disposé à distance spatiale, en particulier via LAN, radio et/ou Internet.

7. Système de parafoudres (1) selon l'une des revendications précédentes, **caractérisé en ce que** les parafoudres (2) sont conçus pour des moyennes et/ou hautes tensions.

8. Procédé de détection de défauts sur un système de parafoudres comportant des parafoudres (2) connectés en parallèle selon l'une des revendications précédentes, **caractérisé en ce qu'**une comparaison, en particulier de valeurs de mesure actuelles des parafoudres (2) et/ou de capteurs (3) des parafoudres (2), est effectuée, un défaut étant détecté en cas d'écarts entre des valeurs de mesure de différents parafoudres (2), et le système de parafoudres (1) étant identifié comme exempt de défauts en cas de valeurs de mesure sensiblement identiques des parafoudres (2), en particulier de tous les parafoudres (2).

9. Procédé selon la revendication 8, **caractérisé en ce que** des valeurs de mesure des parafoudres (2) comprennent des valeurs de courant, en particulier des valeurs de courant de fuite, et/ou **en ce que** des valeurs de mesure des parafoudres comprennent des valeurs de température, en particulier la température de parafoudres (2) individuels.

10. Procédé selon l'une des revendications 8 ou 9, **caractérisé en ce que** des valeurs de mesure sont mesurées par des capteurs (3) respectivement sur chaque parafoudre (2), en particulier pour le courant et/ou la température de chaque parafoudre (2) du système de parafoudres (1).

11. Procédé selon l'une des revendications 8 à 10, **caractérisé en ce que** des valeurs de mesure, en particulier de tous les parafoudres (2), sont mesurées de manière commune, en particulier des valeurs de température par au moins une caméra thermique.

12. Procédé selon l'une des revendications 8 à 11, **caractérisé en ce qu'**une comparaison est effectuée entre des valeurs de mesure des parafoudres (2) et/ou de capteurs (3) des parafoudres (2) qui ont été mesurées sur une courte période, en particulier sur une période de nanosecondes, de millisecondes, de secondes et/ou de minutes, et/ou **en ce que** le procédé est mis en œuvre et/ou respectivement achevé, en particulier de manière répétée, sur une période de nanosecondes, de millisecondes, de secondes et/ou de minutes.

13. Procédé selon l'une des revendications 8 à 12, **caractérisé en ce que**, lors d'une détection d'au moins un parafoudre (2) défectueux, un message d'avertissement et/ou une information sont émis localement et/ou dans au moins un poste de commande central et/ou sur des appareils portables, en particulier de manière automatique, notamment sous la forme d'un signal sonore d'avertissement et/ou d'un signal lumineux et/ou d'un message d'avertissement électronique.
